Europäisches Patentamt

European Patent Office

Office européen des brevets

(19)

(11) **EP 1 401 106 A1**

(12) **EUROPEAN PATENT APPLICATION**
published in accordance with Art. 158(3) EPC

(43) Date of publication:
 **24.03.2004 Bulletin 2004/13**

(51) Int Cl.⁷: **H03M 7/30**

(21) Application number: **02730798.2**

(86) International application number:
 **PCT/JP2002/005287**

(22) Date of filing: **30.05.2002**

(87) International publication number:
 **WO 2002/101934 (19.12.2002 Gazette 2002/51)**

(84) Designated Contracting States:
 **AT BE CH CY DE DK ES FI FR GB GR IE IT LI LU
 MC NL PT SE TR**

(30) Priority: **06.06.2001 JP 2001171739
 21.06.2001 JP 2001188181**

(71) Applicant: **Seiko Epson Corporation
 Shinjuku-ku, Tokyo 163-0811 (JP)**

(72) Inventor: **HAGIWARA, Norihisa,
 c/o Seiko Epson Corporation
 Suwa-shi, Nagano 392-8502 (JP)**

(74) Representative: **Hoffmann, Eckart, Dipl.-Ing.
 Patentanwalt,
 Bahnhofstrasse 103
 82166 Gräfelfing (DE)**

(54) **DECODING APPARATUS, DECODING METHOD, LOOKUP TABLE, AND DECODING PROGRAM**

(57)     A decoder has decoding means 101 for decoding encoded data combined into a block, placement means 102 for placing a decoding result obtained by the decoding means 101 at a position determined with a skip by the amount corresponding to the number of 0s if 0 is included in the decoding result to combine the decoding result into a block, and rearrangement table 103 in which an order in which decoding results are rearranged is registered. The placement means 102 places each of decoding results obtained by the decoding means 101 at a position after rearrangement with a skip by the amount corresponding to the number of 0s while referring to the rearrangement table 103.

*F I G. 1*

**Description**

Technical Field

The present invention relates to a decoder, a decoding method, a lookup table and a decoding program. In particular, the present invention is suitably used for decoding of moving image data.

Background Art

The MPEG-4 (Moving Picture Experts Group Phase 4) system is known as a moving picture coding system standardized mainly for use on the Internet or a wireless network.

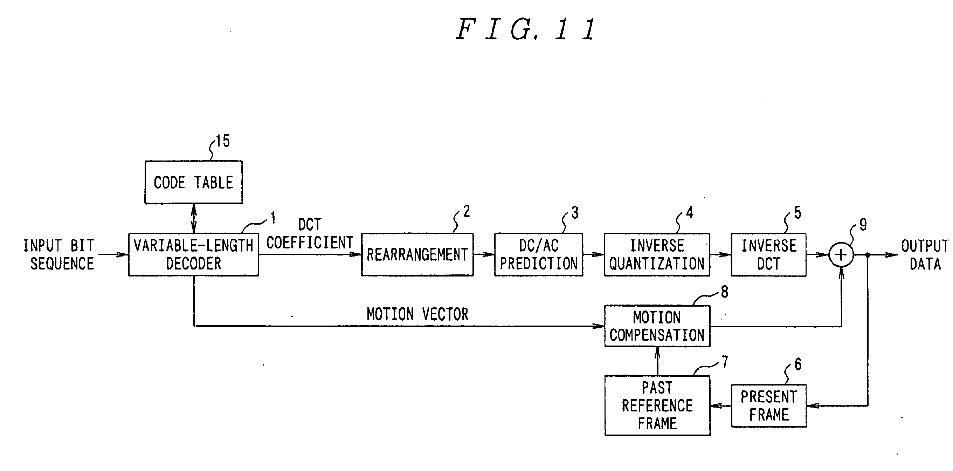

Figure 11 is a block diagram showing an example of a configuration of a decoder according to the MPEG-4 system.

Referring to Figure 11, when an input bit sequence encoded by variable-length coding is input to a variable-length decoder 1, the variable-length decoder 1 decodes variable-length codes on the basis of the result of reference to a code table 15 to obtain DCT (Discrete Cosine Transform) coefficients, motion vectors and header information. In the code table 15 is registered the correspondence relationship between variable-length codes and DCT coefficients, variable-length codes and motion vectors, or variable-length codes and header information.

DCT coefficients decoded by the variable-length decoder 1 are output to a rearrangement section 2. The DCT coefficients zigzag-scanned or alternate-scanned are thereby rearranged in raster scan order.

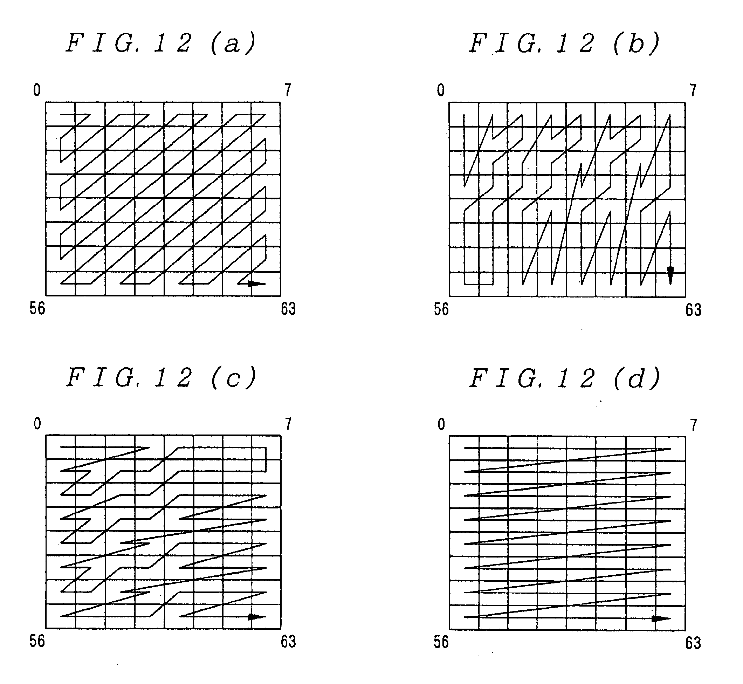

Figure 12 is a diagram showing a method of scanning DCT coefficients in the MPEG-4 system. Referring to Figure 12, zigzag scan is shown in Figure 12 (a) , alternate-vertical scan in Figure 12 (b) , an alternate-horizontal scan in Figure 12 (c), and raster scan in Figure 12(d). DCT coefficients in an $8 \times 8$ block are scanned in the order shown in these sections of Figure 12.

For any of inter macroblocks, zigzag scan is performed. On the other hand, for intra macroblocks, zigzag scan is performed if prediction of AC components is invalid; alternate-vertical scan shown in Figure 12(b) is performed when object block prediction from a left adjacent block is performed; and alternate-horizontal scan shown in Figure 12 (c) is performed when object block prediction from an upper adjacent block is performed.

"Macroblock" refers to a region defined as a block of $16 \times 16$ pixels for dividing a frame. For an inter macroblock, the difference between the present frame and a past or future frame is treated as an encoding object. For an intramacroblock, the signal of the present frame is treated as an encoding object.

The DCT coefficients rearranged in raster scan order are output to a DC/AC prediction section 3 and true DCT coefficients are restored therefrom by performing addition of predicted values of the DCT coefficients on all the DC components and prediction-processed AC components of the intra block. The DCT coefficients obtained by the DC/AC prediction section 3 are output to an inverse quantization section 4 to undergo inverse quantization. In the MPEG-4 system, inverse quantization is performed by selecting an inverse quantization method in accordance with the H.263 system or an MPEG system as desired. If an MPEG-system inverse quantization method is selected, a means to cope with an inverse DCT mismatch, adopted in the MPEG-2 system, is used to reduce an error in computation accuracy.

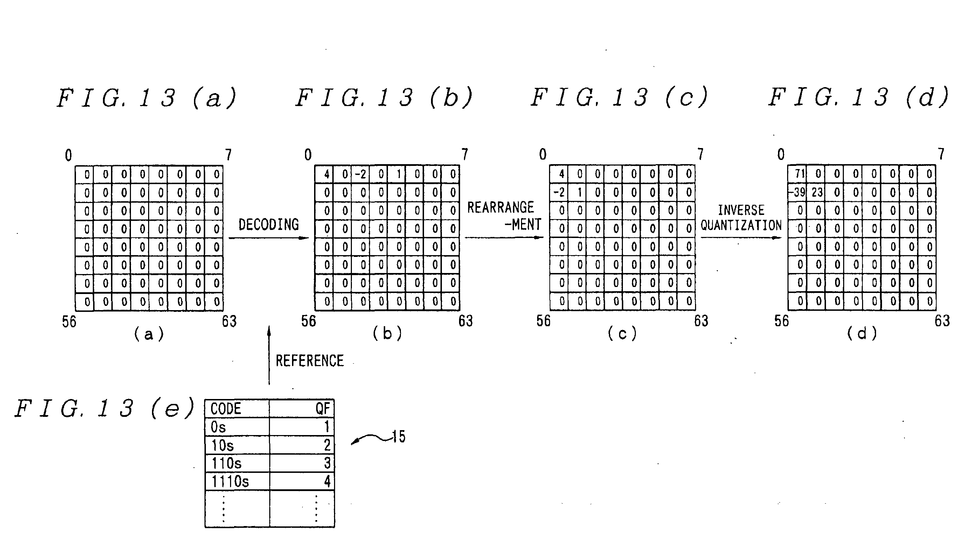

Figure 13 is a diagram showing a method of decoding DCT coefficients in the MPEG-4 system with respect to an example of an inter macroblock.

Referring to Figure 13(a), the variable-length decoder 1 initializes an $8 \times 8$ block and obtains, by referring to the code table 15, DCT coefficients QF corresponding to codes which are input as a bit sequence. Figure 13(e) is a diagram showing the correspondence relationship between codes and DCT coefficients QF registered in the code table 15.

Referring to Figure 13(e), codes "0s", "10s", "110s", and "1110s" are assigned to DCT coefficients QF = "1", "2", "3", and "4", respectively. In these codes, "s" has value 0 or 1 and indicates that QF is plus if "s" = 0, and that QF is minus if "s" = 1.

The variable-length decoder 1 obtains DCT coefficients QF from the code table 15 and arranges the DCT coefficients QF in decoding order in an initialized block shown in Figure 13 (a) , as shown in Figure 13(b). For example, if values "4, 0, -2, 0, 1, 0, 0, ..." are successively obtained as a result of decoding of DCT coefficients QF, these DCT coefficients QF are arranged in the corresponding order in the block.

In the block shown in Figure 13 (b) , DCT coefficients QF are arranged in zigzag scan order. Accordingly, the rearrangement section 2 scans the DCT coefficients QF combined into the block as shown in Figure 13 (b) and rearranges in raster scan order, as shown in Figure 13(c), the DCT coefficients QF shown in Figure 13(b). The result of this rearrangement is such that the DCT coefficient QF = "-2" placed in the second position in the block shown in Figure 13 (b) is placed in the eighth position, and the DCT coefficient QF = "1" placed in the fourth position in the block shown in Figure 13 (b) is placed in the ninth position.

After the completion of rearrangement of the DCT coefficients QF, the inverse quantization section 4 successively scans the DCT coefficients QF combined into the block shown in Figure 13 (c) and makes a determination as to whether each DCT coefficient QF is "0". The inverse quantization section 4 dequantizes the DCT coefficients QF shown in Figure 13 (c) by performing processing for computation of non-zero DCT coefficients QF.

In the MPEG-4 system, inverse quantization in the case where a DCT coefficient QF is plus is performed as shown by the following equations.

**.** In the case of an intra macroblock,
if the intra macroblock is a block quantized by the H.263 system,

$$F = (2|QF| + 1) \cdot QP\text{-}d \qquad (1)$$

if the intra macroblock is a block quantized by an MPEG system,

$$F = |QF| \cdot QP \cdot QM/8 \qquad (2)$$

**.** In the case of an inter macroblock,
if the inter macroblock is a block quantized by the H.263 system,

$$F = (2|QF| + 1) \cdot QP\text{-}d \qquad (3)$$

if the inter macroblock is a block quantized by an MPEG system,

$$F = (2|QF| + 1) \cdot QP \cdot QM/16 \qquad (4)$$

If QP is an odd number, d = 0.

If QP is an even number, d = 1.

QF is each DCT coefficient, F is the value after inverse quantization, QP is a quantization parameter, and QM is the value of a quantizationmatrix corresponding to the coefficient position.

When the DCT coefficient QF is minus, the sign of F is inverted at the end of computation of equations (1) to (4).

The DC component of an intra block does not conform to the equation (1) or (2) and it is multiplied by a constant defined according to the quantization parameter QP.

For example, if quantization is performed by the H.263 system; the block on which inverse quantization is performed is an inter block; and the quantization parameter QP is 8, QF = "4", "-2", and "1" in the block shown in Figure 13(c) are respectively converted into F = "71", "-39", and "23" in the block shown in shown in Figure 13 (d) by inverse quantization processing.

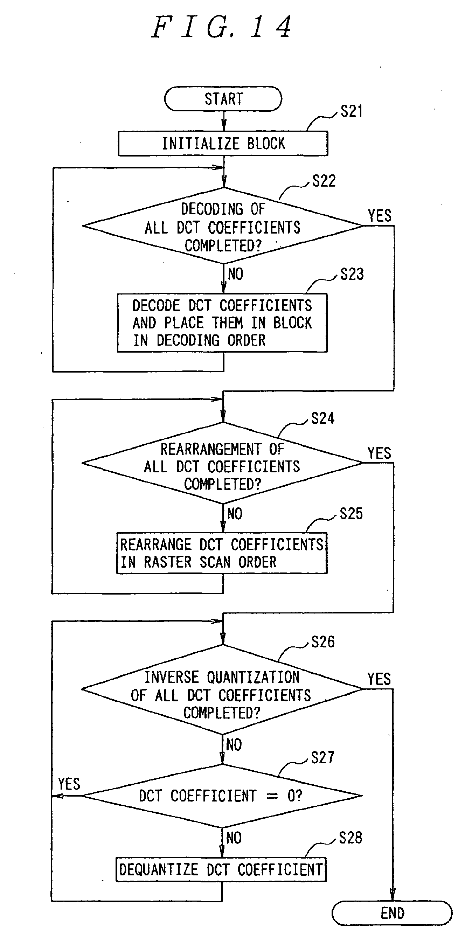

Figure 14 is a flowchart showing a method of decoding DCT coefficients in theMPEG-4 systemwith respect to an example of an inter macroblock.

Referring to Figure 14, the variable-length decoder 1 initializes a block (step S21) and decodes variable-length encoded DCT coefficients by referring to the code table 15 (step S23).

After the completion of decoding of all the DCT coefficients in the block (step S22), the rearrangement section 2 scans all the decoded DCT coefficients (step S24) and thereby rearranges the DCT coefficients in raster scan order (step S25).

Subsequently, the inverse quantization section 4 makes a determination as to whether inverse quantization of all the DCT coefficients in the block is completed (step S26). If inverse quantization of all the DCT coefficients in the block is not completed, the inverse quantization section 4 makes a determination as to whether one of the DCT coefficients is "0" (step S27). If the DCT coefficient is not "0", it dequantizes the DCT coefficient (step S28). These processing steps are repeated until inverse quantization of all the DCT coefficients in the block is completed.

The DCT coefficients after inverse quantization, combined into the block, are output to an inverse DCT section 5, undergo inverse discrete cosine transform, and are thereafter output to an adder 9.

On the other hand, a motion vector decoded by the variable-length decoder 1 is output to a motion compensation section 8 and a predicted value obtained from a neighbor motion vector is added to obtain an actual motion vector. Motion compensation is made by using this motion vector and a past reference frame 7 and the result of the compensation is output to the adder 9.

The adder 9 adds together the inverse DCT computation result output from the inverse DCT section 5 and the compensation result output from the motion compensation section 8, and outputs the result of this addition as a present frame 6. Consequently, the inverse DCT computation result is output as present frame 6 in the case of an intra macroblock, or the value of the result of addition of the inverse DCT computation result and the motion compensation result is output as present frame 6 in the case of an inter macroblock.

In the conventional DCT coefficient decoding method, however, all DCT coefficients in a block are decoded and rearrangement of the DCT coefficients is thereafterperformed.

Thus, there has been a problem that it is necessary to scan all the DCT coefficients in a block two times (steps S22 and S25 in Figure 14) in order to perform decoding and rearrangement of the DCT coefficients in the block, and that the load in decoding processing is thereby increased.

Further, in the conventional DCT coefficient decoding method, all the sixty-four DCT coefficients in Figure 13(b) are rearranged and processing for first initializing a block to "0" and then substituting "0" is therefore performed frequently. Thus, there has been a problem that useless rearrangement occurs. In particular, a moving image has such a large proportion of "0s" in a block that the inefficiency due to rearrangement is considerable.

Also, in the conventional DCT coefficient inverse quantization method, there is a need to perform computation processing of equations (1) to (4) after decoding the DCT coefficients and the load on inverse quantization processing is large.

Further, in the conventional DCT coefficient inverse quantization method, there is a need to make a determination as to whether the DCT coefficient is "0" with respect to each of the sixty-four DCT coefficients combined into a block as shown in Figure 13(c), so that the efficiency of inverse quantization processing is low.

Therefore it is a first object of the present invention to provide a decoder, a decoding method, a lookup table and a decoding program capable of reducing the load at the time of rearrangement of decoding results.

It is a second object of the present invention to provide a decoder, a decoding method and a decoding program capable of improving the efficiency of inverse quantization processing.

Disclosure of the Invention

To solve the above-described problems, according to the present invention, there is provided a decoder having decoding means for decoding encoded data combined into a block, and placement means for placing a decoding result obtained by the decoding means at a position determined with a skip by the amount corresponding to the number of 0s if 0 is included in the decoding result.

It is thereby ensured that processing including substitution in the block can be omitted with respect to a decoding result value of 0 to increase the decoding processing speed.

In another form of the decoder according to the present invention, the placement means directly places the decoding result at the position after rearrangement.

The need for scanning decoding results for rearrangement of the decoding results is thereby eliminated, thus making it possible to increase the decoding processing speed.

In still another form of the decoder according to the present invention, there are provided decoding means for decoding encoded data combined into a block, inverse quantizationmeans for dequantizing a decoding result obtained by the decoding means with a skip by the amount corresponding to the number of 0s if 0 is included in the decoding result, andplacement means for directly placing a result of the inverse quantization at a position after rearrangement.

The need for scanning decoding results for rearrangement of the decoding results is thereby eliminated, and it is ensured that inverse quantization processing can be omitted with respect to the decoding result value 0, thus making it possible to increase the decoding processing speed.

In still another form of the decoder according to the present invention, there are provided decoding means for decoding encoded data while performing part of computation processing for inverse quantization, and inverse quantization means for dequantizing an output result from the decodingmeans by performing the rest of computation processing other than the part of computation processing performed by the decoding means.

It is thereby ensured that the loadon inverse quantization processing can be reduced and the efficiency of inverse quantization processing can be improved.

In still another form of the decoder according to the present invention, there are provided a rearrangement table in which a decoding result rearrangement order is registered, and decoding and rearrangement means for performing rearrangement of a decoding result with reference to the rearrangement table while performing decoding.

It is thereby ensured that the same control structures used for decoding processing and rearrangement processing can be combined into one to eliminate the need for repeating the same control, thus making it possible to reduce the load at the time of rearrangement of the decoding results.

In still another form of the decoder according to the present invention, there are provided a rearrangement table in which an order in which DCT coefficients are rearranged in a block is registered, and decoding and rearrangement means for placing a non-zero DCT coefficient in an initialized block in the order designated by the rearrangement table each time it decodes a DCT coefficient.

It is thereby ensured that decoding and rearrangement of the DCT coefficients in the block canbe performedby scanning all the DCT coefficients in the block only one time, and the processing such as first initializing the block to "0" and thereafter substituting "0" can be omitted, thus making it possible to reduce the load at the time of rearrangement of the decoding results.

In still another form of the decoder according to the present invention, the decoding and rearrangement means skips reference to the rearrangement table and substitution in the block by the amount corresponding to the number of 0s included in a decoding result if 0 is included in the decoding result.

It is thereby ensured that reference to the rearrangement table and substitution in the block can be omitted with respect to the decoding result value "0", thus making it possible to increase the decoding processing speed.

In still another form of the decoder according to the present invention, there are provided a lookup table in which a result of computation of an information source is registered in correspondence with a code assigned to the information source, acquisition means for obtaining the result of computation of the encoded information source by referring to the lookup table, and inverse quantization means for performing inverse quantization on the basis of the obtained computation result.

It is thereby ensured that the result of computation of the decoded information source can be obtained by only performing decoding processing on the information source, and at least part of computation processing for inverse quantization can be performed for processing for decoding the information source without increasing the load at the time of decoding of the information source, thus making it possible to improve the efficiency of inverse quantization processing.

In still another form of the decoder according to the present invention, if the information source is X, the computation result is 2X + 1.

It is thereby ensured that part of computation processing in inverse quantization processing can be performed simultaneously with decoding, thus making it possible to improve the efficiency of inverse quantization processing without increasing the load of other processings.

In still another form of the decoder according to the present invention, there are provided decoding and inverse quantization means for performing inverse quantization while performing decoding, and block-forming means for combining a result of inverse quantization performed by the decoding and inverse quantization means into a block.

It is thereby ensured that the same control structures used for decoding processing and inverse quantization processing can be combined into one to eliminate the need for repeating the same control of determination processing, loop processing or branching processing, thus making it possible to reduce the load at the time of inverse quantization processing.

In still another form of the decoder according to the present invention, there is provided a lookup table in which a result of computation of an information source is registered in correspondence with a code assigned to the information source, and the decoding and inverse quantizationmeans obtains the result of computation of the encoded information source by referring to the lookup table and performs inverse quantization on the basis of the obtained computation result.

It is thereby ensured that the need for performing control of determination processing or loop processing for inverse quantization only can be eliminated and the load on computation processing performed in inverse quantization processing can be reduced, thus making it possible to further improve the efficiency of inverse quantization processing.

In still another form of the decoder according to the present invention, there is provided a rearrangement table in which a decoding result rearrangement order is registered, and the decoding and inverse quantization means performs inverse quantization of the decoding result on the basis of a result of reference to the decoding result rearrangement order.

It is thereby ensured that even in a case where there is a need to fix the decoding result rearrangement order at the time of inverse quantization, inverse quantization can be performed without substituting the decoding result in the block, thus making it possible to reduce the load at the time of inverse quantization processing.

In still another form of the decoder according to the present invention, the block-forming means combines into a block a result of the inverse quantization in the order after rearrangement by referring to the rearrangement table.

It is thereby ensured that the same control structures used for decoding, rearrangement and inverse quantization can be combined into one and the same control separately performed for each of these three kinds of processing can be performed at a time, thus making it possible to further reduce the load at the time of inverse quantization processing.

In still another form of the decoder according to the present invention, there is further provided initialization means for initializing the block, and the decoding and inverse quantization means skips inverse quantization by the amount corresponding to the number of 0s included in a decoding result if 0 is included in the decoding result.

It is thereby ensured that determination as to "0"/non-"0" at the time of inverse quantization can be omitted to improve the efficiency of inverse quantization processing.

In still another form of the decoder according to the present invention, the block-forming means skips reference to the rearrangement table and substitution in the block by the amount corresponding to the number of "0s".

It is thereby ensured that reference to the rearrangement table and substitution in the block can be omitted with respect to the decoding result value "0" and inverse quantization can be performed by performing processing with respect to non-zero DCT coefficients only, thus making it possible to increase the decoding processing speed.

A decoding method according to the present invention decodes codes while placing results of decoding in an order different from the order in which the codes are decoded.

It is thereby ensured that rearrangement can be completed simultaneously with the completion of decoding and there is no need to perform rearrangement after the completion of decoding, thus making it possible to reduce the load at the time of rearrangement of the decoding results and to increase the decoding speed.

In another form of the decoding method according to the present invention, there are provided a step of initializing a block in which DCT coefficients are placed, and a step of placing a non-zero DCT coefficient in the block, skipping processing after the initializing step regarding "0", if information indicating "0" is included in a decoding result.

It is thereby ensured that combing of the DCT coefficients into a block can be completed by performing processing on non-zero DCT coefficients only, and useless processing such as first initializing a block to "0" and thereafter substituting "0" can be eliminated, thus making it possible to perform decoding processing on the DCT coefficients with improved efficiency.

In another form of the decoding method according to the present invention, there are provided a step of initializing a block in which DCT coefficients are placed, a step of decoding an encoded DCT coefficient, a step of obtaining a rearrangement order in which a non-zero DCT coefficient is placed each time decoding of a DCT coefficient is performed, and a step of placing the non-zero DCT coefficient in the initialized block in the obtained rearrangement order.

It is thereby ensured that decoding and rearrangement of the DCT coefficients in the block can be simultaneously performed by scanning all the DCT coefficients in the block only one time, and the need to again scan the DCT coefficients in the block only for rearrangement is eliminated, thus making it possible to reduce the load at the time of rearrangement of the decoding results.

In another form of the decoding method according to the present invention, decoding and inverse quantization are performed at a time with respect to each of blocks.

It is thereby ensured that if control of the same determination processings or loop processings is performed for decoding and inverse quantization, control of these kinds ofprocessingcanbeperformedatatime, thusmakingitpossible to reduce the load at the time of inverse quantization and to increase the decoding speed.

In another form of the decoding method according to the present invention, decoding, rearrangement and inverse quantization are performed at a time with respect to each of blocks.

It is thereby ensured that if control of the same determination processings or loop processings is performed for decoding, rearrangement and inverse quantization, control of these kinds of processing can be performed at a time, thus making it possible to reduce the load at the time of inverse quantization and to increase the decoding speed.

In another form of the decoding method according to the present invention, there are provided a step of performing inverse quantization each time a code is decoded, and a step of combining results of the inverse quantization into a block in an order different from the decoding order.

It is thereby ensured that control of the same determination processings or loop processings for decoding, inverse quantization and rearrangement can be performed as common control and these processings can be performed at a time, thus making it possible to reduce the load at the time of inverse quantization and to increase the decoding speed.

In another form of the decoding method according to the present invention, there are provided a step of initializing a block in which DCT coefficients are placed, a step of skipping inverse quantization processing with respect to "0" if information indicating "0" is included in a decoding result, and a step of dequantizing a decoded non-zero DCT coefficient and placing the result of the inverse quantization in the block.

It is thereby ensured that inverse quantization processing can be performed without making determination as to whether each DCT coefficient is "0", and the efficiency of the inverse quantization processing can be improved.

In another form of the decoding method according to the present invention, there are provided a step of initializing a block in which DCT coefficients are placed, a step of skipping inverse quantization processing with respect to "0" if information indicating "0" is included in a decoding result, a step of obtaining a rearrangement order in which a decoded non-zero DCT coefficient is placed, and a step of dequantizing the non-zero DCT coefficient and placing the result of the inverse quantization in the block in the rearrangement order.

It is thereby ensured that decoding, rearrangement and inverse quantization of the DCT coefficients in the block can be performedby scanning non-zero DCT coefficients in theblock only one time, thus making it possible to reduce the load at the time of inverse quantization

In a lookup table according to the present invention, placement positions for rearranging zigzag-scanned or alternate-scanned DCT coefficients in raster scan order are registered.

It is thereby ensured that rearrangement of the DCT coefficients at the time of decoding can be performed by referring to the lookup table.

In another form of the lookup table according to the present invention, a result of computation of an information source is registered in correspondence with a code assigned to the information source.

It is thereby ensured that the result of computation of the information source can be obtained by only referring to lookup table at the time of decoding of the information source, thus making it possible to reduce the load at the time of computation processing after decoding of the information source.

A decoding program according to the present invention makes a computer execute a step of inputting codes combined into a block, and a step of placing in a block a result of decoding of the codes so that the state in which the result of decoding is newly placed is different from the preceding state of placement of the codes each time decoding is performed on the codes.

It is thereby ensured that the load at the time of rearrangement of the decoding results can be reduced by installing the decoding program, thus making it possible to increase the decoding speed without changing the hardware configuration.

In another form of the decoding program according to the present invention, a computer is made to execute a step of decoding encoded data, and a step of placing a decoding result in a block with a skip by the amount corresponding to the number of 0s if 0 is included in the decoding result.

It is thereby ensured that substitution in the block with respect to the decoding result value 0 can be omitted by installing the decoding program, thus making it possible to increase the decoding speed without changing the hardware configuration.

Another form of the decoding program according to the present invention is characterizedbymakinga computer execute a step of inputting codes combined into a block, a step of performing inverse quantization while decoding the codes, and a step of combining results of the inverse quantization into a block while changing the placement order.

It is thereby ensured that the load at the time of inverse quantization canbe reducedby installing the decoding program, thus making it possible to increase the decoding speed without changing the hardware configuration.

Brief Description of the Drawings

Figure 1 is a block diagram showing the configuration of a decoder according to a first embodiment of the present invention;

Figure 2 is a block diagram showing the configuration of a decoder according to a second embodiment of the present invention;

Figure 3 is a diagram showing a method of decoding DCT coefficients according to the second embodiment of the present invention;

Figure 4 is a flowchart showing the method of decoding DCT coefficients according to the second embodiment of the present invention;

Figure 5 is a block diagram showing the configuration of a decoder according to a third embodiment of the present invention;

Figure 6 is a block diagram showing the configuration of a decoder according to a fourth embodiment of the present invention;

Figure 7 is a diagram showing a method of decoding DCT coefficients according to the fourth embodiment of the present invention;

Figure 8 is a block diagram showing the configuration of a decoder according to a fifth embodiment of the present invention;

Figure 9 is a diagram showing a method of decoding DCT coefficients according to the fifth embodiment of the present invention;

Figure 10 is a flowchart showing the method of decoding DCT coefficients according to the fifth embodiment of the present invention;

Figure 11 is a block diagram showing an example of a configuration of a decoder according to the MPEG-4 system;

Figure 12 is a diagram showing a method of scanning DCT coefficients according to the MPEG-4 system;

Figure 13 is a diagram showing a method of decoding DCT coefficients according to the MPEG-4 system; and

Figure 14 is a flowchart showing the method of decoding DCT coefficients according to the MPEG-4 system.

Best Mode for Carrying Out the Invention

A decoder and a decoding method according to an embodiment of the present invention will be described with reference to the drawings.

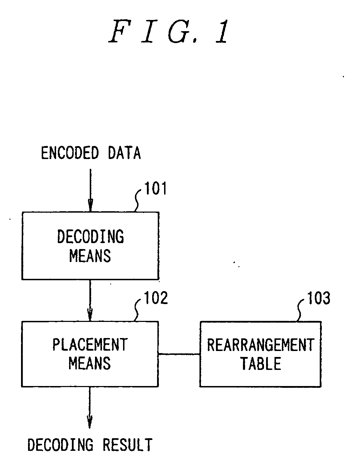

Figure 1 is a block diagram showing the configuration of a decoder according to a first embodiment of the present invention.

Referring to Figure 1, the decoder is provided with decodingmeans 101 andplacementmeans 102. The decoding means 101 decodes encoded data combined into a block, and the placement means 102 combines the results of decoding into a block in such a manner that if 0 is included in the results of decoding performed by the decoding means 101, the corresponding decoding result is placed at a positions determined with a skip by the amount corresponding to the number of 0s.

A rearrangement table 103 is also provided in the decoder and a decoding result rearrangement order is registered in the rearrangement table 103. For example, placement positions for rearrangement in raster scan order of DCT coefficients zigzag-scanned or alternate-scanned may be registered in the rearrangement table 103.

Also, the placement means 102 can directly place the decoding results from the decoding means 101 at the positions after rearrangement by placing the decoding results from the decoding means 101 in a block with reference to the rearrangement table 103.

Thus, processing on the decoding such as substitution in a block with respect to the decoding result value "0" can be omitted and the need for scanning the decoding results for rearrangement of the decoding results is eliminated. Consequently, the decoding processing speed can be increased.

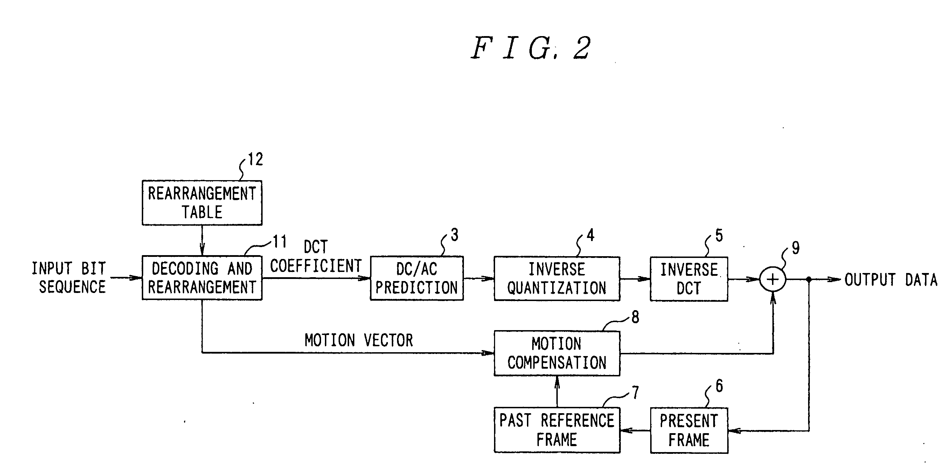

Figure 2 is a block diagram showing the configuration of a decoder according to a second embodiment of the present invention. In the arrangement shown in Figure 2, a decoding and rearrangement section 11 and a rearrangement table 12 are provided in place of the variable-length decoder 1 and the rearrangement section 2 shown in Figure 11. In other respects, the arrangement shown in Figure 2 may be the same as that shown in Figure 11.

The decoding and rearrangement section 11 initializes an $8 \times 8$ block to "0" and refers to the rearrangement table 12 each time it decodes one non-zero DCT coefficient. The decoding and rearrangement section 11 places decoded non-zero DCT coefficients in the 8 × 8 block in an order designated by the rearrangement table 12. After the completion of decoding and rearrangement of all the non-zero DCT coefficients, the decoding and rearrangement section 11 outputs the DCT coefficients combined into the block to the DC/AC prediction section 3.

The decoding and rearrangement section 11 decodes non-zero DCT coefficients, for example, in a unit according to three factors: (the number of "0s"), (the value of each non-zero DCT coefficient) , and (a flag indicating whether the current processing is on the final non-zero coefficient). Reference positions in the rearrangement table 12 are skipped by the amount corresponding to (the number of "0s") included in the decoding result, and the value of the non-zero DCT coefficient is substituted in the placement position indicated by the reference position after the skip.

Thus, decoding and rearrangement of one block can be completed by making reference to the rearrangement table 12 and substitution of a decoding result in the block with respect to non-zero DCT coefficients only, and the decoding processing speed can therefore be increased. In particular, the effect for a moving image is high because the proportion of "0s" in a block of the moving image is large.

In the rearrangement table 12, an order in which DCT coefficients are rearranged in a block is registered. For example, in a case where DCT coefficients to be decoded are zigzag-scanned, positions in a block for rearrangement of the DCT coefficients in raster scan order are registered.

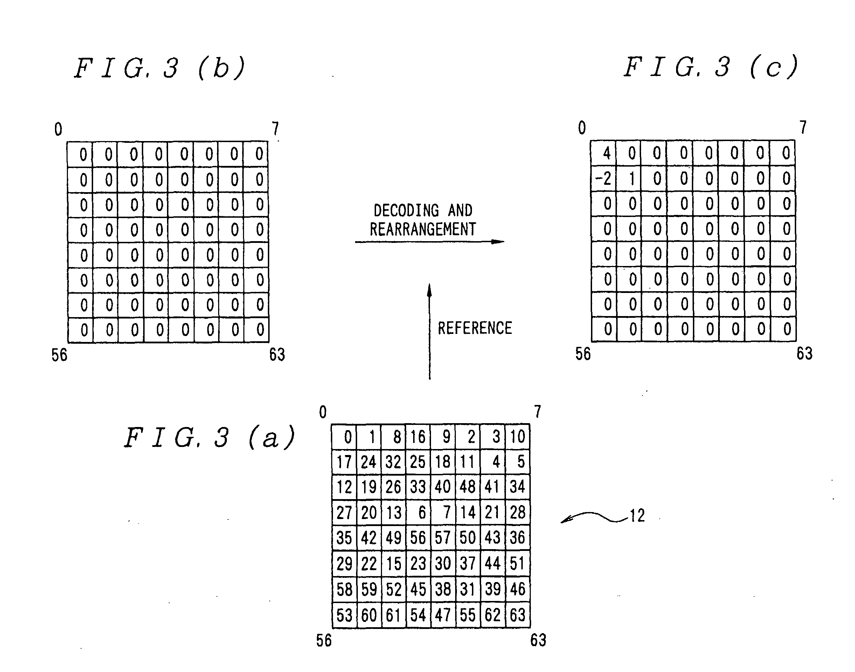

Figure 3(a) is a diagram showing the configuration of the rearrangement table 12 for rearranging in raster scan order DCT coefficients zigzag-scanned.

Referring to Figure 3(a), to rearrange in raster scan order DCT coefficients zigzag-scanned, it is necessary to change the placement of the DCT coefficients so that, for example, the DCT coefficient at the 0th position is placed at the 0th position, the DCT coefficient at the first position is placed at the first position, the DCT coefficient at the second position is placed at the eighth position, and the DCT coefficient at the third position is placed at the sixteenth position. For this rearrangement, the positions after rearrangement of the DCT coefficients are registered in raster scan order in the 8 × 8 block in the rearrangement table 12.

Figure 3 is a diagram showing a method of decoding DCT coefficients according to an embodiment of the present invention. Referring to Figure 3(b), the decoding and rearrangement section 11 shown in Figure 2 initializes an 8 × 8 block to "0".

Subsequently, the decoding and rearrangement section 11 decodes the first DCT coefficient. If, for example, (the number of "0s" = 0), (the non-zero DCT coefficient value = "4") and (the flag indicating whether the current processing is on the final non-zero coefficient = "false") are obtained as a decoding result, the decoding and rearrangement section 11 refers to the rearrangement table 12 in Figure 3 (a) at the 0th position. If the 0th position is thereby obtained as the position at which the decoding result of the 0th DCT coefficient is to be placed, the decoding and rearrangement section 11 places "4" at the 0th position in the block, as shown in Figure 3(c).

Subsequently, the decoding and rearrangement section 11 decodes the next DCT coefficient. I f, for example, (the number of "0s" = 1), (the non-zero DCT coefficient value = "-2") and (the flag indicating whether the current processing is on the final non-zero coefficient = "false") are obtained as a decoding result, the decoding and rearrangement section 11 refers to the rearrangement table 12 in Figure 3(a) at the second position by skipping the reference position by the amount corresponding to the number of "0s" = 1. If the eighth position is thereby obtained as the position at which the decoding result of the non-zero DCT coefficient at the present time is to be placed, the decoding and rearrangement section 11 places the non-zero DCT coefficient value = "-2" at the eighth position in the block, as shown in Figure 3(c).

Since "0" is previously substituted at the time of initialization of the block shown in Figure 3 (b), none of the "0" placement positions becomes empty even though substitution of "0" in the block is performed with a skip by the amount corresponding to the number of "0s" = 1 when "-2" is placed at the eighth position in the block.

Subsequently, the decoding and rearrangement section 11 decodesthenextDCTcoefficient. If, for example, (thenumber of "0s" = 1), (the non-zero DCT coefficient value = "1") and (the flag indicating whether the current processing is on the final non-zero coefficient = "true") are obtained as a decoding result, the decoding and rearrangement section 11 refers to the rearrangement table 12 in Figure 3 (a) at the fourthposition by skipping the reference positions by the amount corresponding to the number of "0s" = 1. If the ninth position is thereby obtained as the position at which the decoding result of the non-zero DCT coefficient at the present time is to be placed, the decoding and rearrangement section 11 places the non-zero DCT coefficient value = "1" at the ninth position in the block, as shown in Figure 3(c). Since (the flag indicating whether the current processing is on the final non-zero coefficient = "true"), the decoding and rearrangement section 11 terminates decoding of the one block and outputs the decoding result corresponding to the 8 × 8 block to the DC/AC prediction section 3.

As described above, rearrangement is performed accompanying decoding to be completed simultaneously with the completion of decoding, and there is no need to redo scanning on DCT coefficients combined into a block since the decoded DCT coefficients are rearranged in raster scan order, so that the decoding processing speed can be increased.

Also, since the decoded DCT coefficients can be placed in a block while being rearranged, the need for the storage area for holding the sixty-four coefficients before rearrangement can be eliminated while only the storage area for holding the sixty-four coefficients after rearrangement is prepared, thus making it possible to reduce the storage capacity.

Also, since decoding is started by initializing the entire block to "0", there is no need for substitution of "0" in a block when the DCT coefficient is "0" and processing can be skipped by the amount corresponding to the number of "0s", thus making it possible to further increase the processing speed.

The embodiment has been described with respect to the method in which the decoding and rearrangement section 11 decodes non-zero DCT coefficients in a unit according to three factors: (the number of "0s"), (the value of each non-zero DCT coefficient), and (a flag indicating whether the current processing is on the final non-zero coefficient). However, decoding may be performed by a method different from this.

For example, non-zero DCT coefficients may be decoded in a unit according to a set of (the number of "0s") and (the value of each non-zero DCT coefficient). In such a case, decoding of one block may be terminated when an EOB (End of Block) code indicating that subsequent coefficients in the block are "0" is decoded.

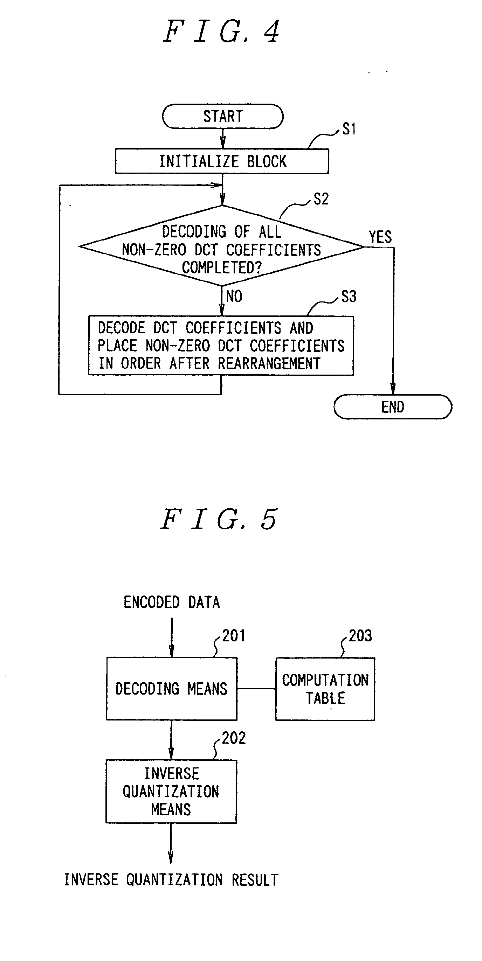

Figure 4 is a flowchart showing a method of decoding DCT coefficients according to an embodiment of the present invention.

Referring to Figure 4, the decoding and rearrangement section 11 initializes a block (step S1).

Next, if decoding of all non-zero DCT coefficients in the block is not completed (step S2), one of the variable-length coded DCT coefficients is decoded, the reference positions in the rearrangement table 12 are skipped by the amount corresponding to (the number of "0s") included in the decoding result to obtain the placement position identified by the reference position after the skip. The decoded non-zero DCT coefficient is then substituted in the placement position obtained from the rearrangement table 12.

The above-described processing is performed on all the non-zero DCT coefficients. After the completion of processing on all the non-zero DCT coefficients, the DCT coefficients combined into a block are output to the DC/AC prediction section 3.

As described above, rearrangement of DCT coefficients is performed with reference to the rearrangement table 12 accompanying decoding of the DCT coefficients. In this manner, the results of decoding and rearrangement of all the DCT coefficients in one block can be completed by scanning the non-zero DCT coefficients one time (step S2 in Figure 4), thus making it possible to reduce the load in decoding processing.

While the embodiment has been described with respect to an application to the MPEG-4 system, applications to other systems are also possible. For example, an application to the MPEG-1 or MPEG-2 system or to the JPEG (Joint Photographic Experts Group) system is also possible.

While an example of the arrangement table 12 in the case where DCT coefficients are zigzag-scanned has been described, an application to alternate scan is also possible. Also, the rearrangement table 12 may be changed in correspondence with zigzag scan or alternate scan.

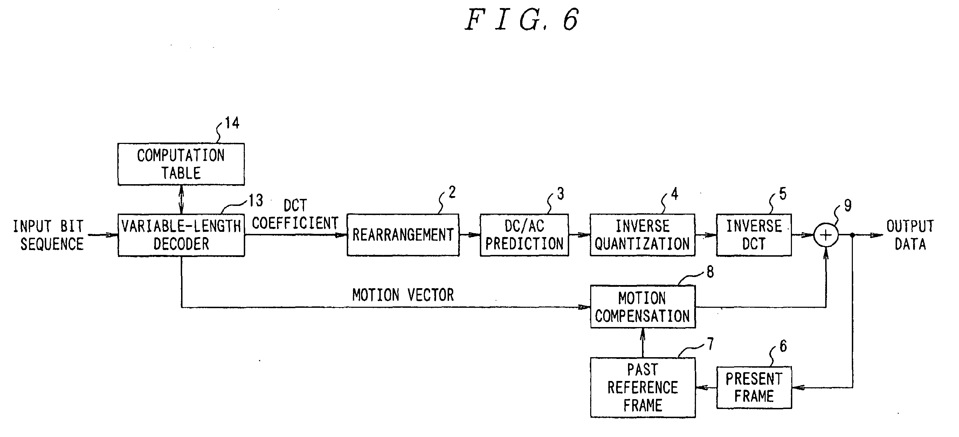

Figure 5 is a block diagram showing the configuration of a decoder according to a third embodiment of the present invention.

Referring to Figure 5, the decoder is provided with decoding means 201 and inverse quantization means 202. The decoding means 201 decodes encoded data while performing part of computation processing for inverse quantization, and the inverse quantizationmeans 202 performs the rest of computation processing other than that performed by the decoding means 201 to dequantize the result output from the decoding means 201.

A computation table 203 is also provided in the decoder and the correspondence relationship between a code assigned to an information source and the result of computation of the information source is registered in the computation table 203. For example, if the information source is X, value 2X + 1 may be registered as the result of computation of the information source.

When an encoded data is input to the decoding means 201, the decoding means 201 obtains the result of computation of the information source corresponding to the encoded data by referring to the computation table 203 and outputs the result of computation of the information source to the inverse quantization means 202.

The inverse quantization means 202 performs computation processing for inverse quantization on the result of computation of the information source received from the decoding means 201.

Thus, the decoding means 201 can complete part of computation processing for inverse quantization by only obtaining the result of computation of the information source from the computation table 203, and the inverse quantization means 202 can complete inverse quantization by performing the reset of the computation processing.

Therefore, the load on inverse quantization processing performed by the inverse quantization means 202 can be reduced without increasing the load on the decoding means 201, thus making it possible to improve the efficiency of inverse quantization processing.

Figure 6 is a block diagram showing the configuration of a decoder according to a fourth embodiment of the present invention. In the fourth embodiment, when an encoded DCT coefficient is decoded, decoding is performed not by obtaining the DCT coefficient itself from a table but by obtaining the result of computation of the DCT coefficient from a table to reduce the load on inverse quantization processing thereafter performed without increasing the load at the time of decoding of the DCT coefficient.

In the arrangement shown in Figure 6, a variable-length decoder 13 and a computation table 14 are provided in place of the variable-length decoder 1 and the code table 15 shown in Figure 11. In other respects, the arrangement shown in Figure 6 may be the same as that shown in Figure 11.

Referring to Figure 6, the variable-length decoder 13 refers to the computation table 14 instead of the code table 15 shown in Figure 11 with respect to an inter macroblock, obtains from the computation table 14 the results of computation of the DCT coefficients corresponding to codes input as a bit sequence, and outputs the results of computation of the DCT coefficients to the rearrangement section 2.

In the computation table 14, the results of computation of DCT coefficients are stored in correspondence with codes assigned to the DCT coefficients. When an inter macroblock is dequantized, computation of $(2|QF| + 1)$ is performed as shown by the equation (3) or (4) regardless of whether the block has been quantizedby the H. 2 63 system or the MPEG system.

Accordingly, in the computation table 14, the computation results QF' which are $(2|QF| + 1)$ are registered in correspondence with the codes assigned to the DCT coefficients QF.

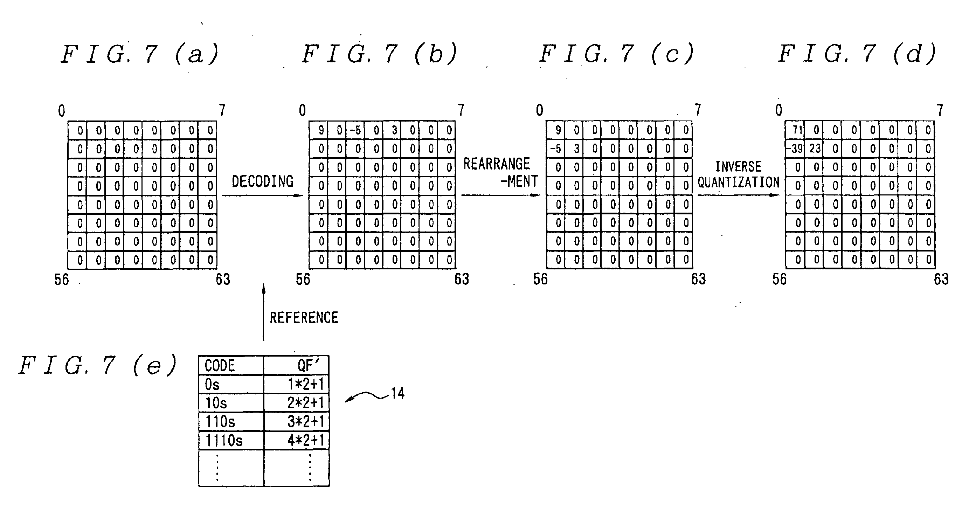

Figure 7 (e) is a diagram showing an example of the results of computation of DCT coefficients registered in the computation table 15.

Referring to Figure 7(e), in the computation table 15, the results of computation of the DCT coefficients QF: QF' = $(2|QF| + 1)$ = "1 $\times$ 2 + 1", "2 $\times$ 2 + 1", "3 $\times$ 2 + 1", and "4 $\times$ 2 + 1" are respectively registered in correspondence with codes "0s", "10s", "110s", and "1110s" defined in the code table 15 shown in Figure 11.

The variable-length decoder 13 obtains, in the case of an inter macroblock, the computation results $(2|QF| + 1)$ corresponding to the input codes by referring to the computation table 14 shown in Figure 7(e). If "s" contained in the input code is 0, the variable-length decoder 13 immediately combines the computation results $(2|QF| + 1)$ obtained from the computation table 14 into a block. If "s" contained in the input code is 1, the variable-length decoder 13 combines the computation results $(2|QF| + 1)$ obtained from the computation table 11 into a block by inverting the plus/minus sigh thereof. After the completion of combining into the 8 $\times$ 8 block, the variable-length decoder 13 outputs the results QF' of computation of the DCT coefficients combined into the block to the rearrangement section 2.

The inter macroblock output to the rearrangement section 2 is rearranged in raster scan order in the rearrangement section 2 and thereafter output to the inverse quantization section 4 to undergo inverse quantization by the equation (3) or (4).

Since computation of $(2|QF| + 1)$ in the computation performed by the equation (3) or (4) has already been performed, there is no need to perform computation of $(2|QF| + 1)$ in the inverse quantization section 4, thus making it possible to reduce the load at the time of inverse quantization.

Figure 7 is a diagram showing a method of decoding an inter macroblock according to the fourth embodiment of the present invention.

Referring to Figure 7(a), the variable-length decoder 13 shown in Figure 6 initializes an 8 $\times$ 8 block to "0" and obtains, by referring to the computation table 14 in Figure 7(e), the results $(2|QF| + 1)$ of computation of the non-zero DCT coefficients QF corresponding to codes which are input as a bit sequence. Then, as shown in Figure 7(b), the variable-length decoder 13 rearranges in the decoding order the results QF' of computation of the DCT coefficients QF, whose plus or minus sign has been determined according to the value of "s", in the initialized block shown in Figure 7 (a).

For example, if the results of decoding of the DCT coefficients QF are "4, 0, -2, 0, 1, 0, 0, ...", the results QF' "9, 0, -5, 0, 3, 0, 0, ..." of computation of the DCT coefficients QF can be directly obtained by referring to the computation table 14 in Figure 7(e) without obtaining the results "4, 0, -2, 0, 1, 0, 0, ..." of decoding of the DCT coefficients QF.

In the inter macroblock shown in Figure 7 (b), the results QF' of computation of the DCT coefficients QF are arranged in zigzag scan order. Therefore, as shown in Figure 7(c), the rearrangement section 2 rearranges in raster scan order the results QF' of computation of the DCT coefficients QF shown in Figure 7 (b) by scanning the results QF' of computation of the DCT coefficients QF combined into the block shown in Figure 7 (b). As a result of this rearrangement, the DCT coefficient QF = "-5" placed in the second position in the block shown in Figure 7(b) is placed in the eighth position as shown in Figure 7(c), and the DCT coefficient QF = "3" placed in the fourth position in the block shown in Figure 7(b) is placed in the ninth position as shown in Figure 7 (c).

After the completion of rearrangement of the results QF' of computation of the DCT coefficients QF, the inverse quantization section 4 successively scans the results QF' of computation of the DCT coefficients QF combined into the block shown in Figure 7(c), and dequantizes the DCT coefficients QF by performing the following computation processing with respect to the results QF' of computation of the non-zero DCT coefficients QF.

For example, in the case where the DCT coefficients QF are quantized by the H.263 system, the following equations can be used.

.    If QP is an even number,

$$F = QF' \cdot QP - 1 \ (QF' > 0) \qquad (5)$$

$$F = QF' \cdot QP + 1 \ (QF' < 0) \qquad (6)$$

. If QP is an odd number,

$$F = QF' \cdot QP \qquad (7)$$

If the quantization parameter QP is 8, QF = "9", "-5", and "3" in the block in Figure 7 (c) are respectively converted into F = "71", "-39", and "23" in the block in Figure 7(d) by using the equation (5) or (6).

The fourth embodiment has been described with respect to a method of processing an inter macroblock. In the case of an intra macroblock, addition of predicted values of DCT coefficients on all the DC components and prediction-processed AC components is performed in the DC/AC prediction section 3. In processing performed in the DC/AC prediction section 3, not (2|QF| + 1) but QF is used. Therefore, if the computation results (2|QF| + 1) obtained from the computation table 14 are output to the DC/AC prediction section 3, the load on processing in the DC/AC prediction section 3 is increased instead of being reduced.

In the case where an intra macroblock is quantized by the H.263 system, the value (2|QF| + 1) is used in inverse quantization processing as shown by the equation (1). In the case where an intra macroblock is quantized by the MPEG system, the value of QF is directly used in inverse quantization processing, as shown by the equation (2), and the value (2|QF| + 1) is not necessary.

In the case of an intra macroblock, therefore, it is preferable to perform decoding by using the code table 15 shown in Figure 11 instead of using the computation table 14 shown in Figure 7.

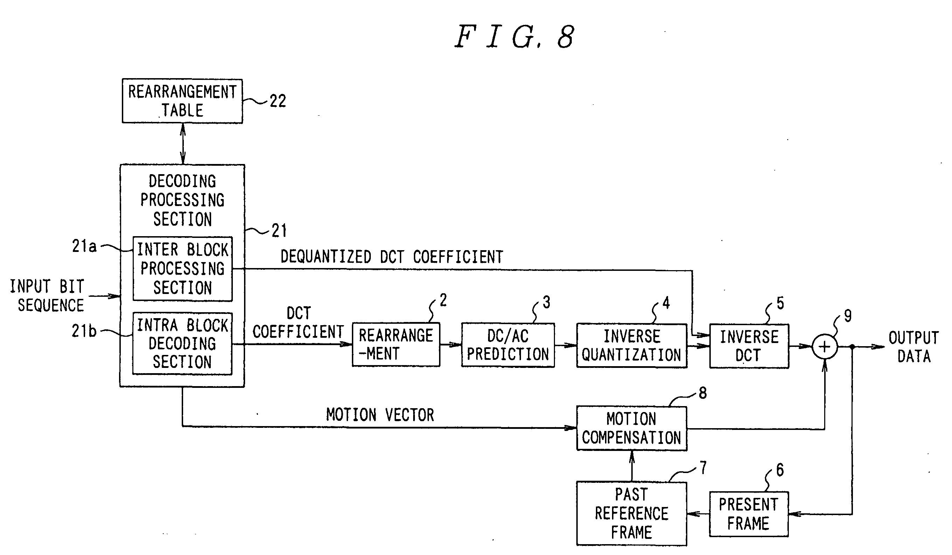

Figure 8 is a block diagram showing the configuration of a decoder according to a fifth embodiment of the present invention. In the fifth embodiment, when an encoded DCT coefficient is decoded, inverse quantization processing is simultaneously performed so that the efficiency of inverse quantization processing can be improved.

In the arrangement shown in Figure 8, a decodingprocessing section 21 and a rearrangement table 22 are provided in place of the variable-length decoder 1 and the code table 15 shown in Figure 11. In other respects, the arrangement shown in Figure 8 may be the same as that shown in Figure 11.

Referring to Figure 8, the decoding processing section 21 includes an inter block processing section 21a and an intra block decoding section 21b.

The inter block processing section 21a performs inverse quantization of a DCT coefficient in an inter block while decoding the DCT coefficient. Each time the inter block processing section 21a obtains a non-zero inverse quantization result, it combines the non-zero inverse quantization result into a block in the order after rearrangement by referring to the rearrangement table 22. After the completion of combining of DCT coefficients into the $8 \times 8$ block, the inter block processing section 21a outputs the inverse quantization results combined into the block to the inverse DCT section 5.

The inter block processing section 21a decodes non-zero DCT coefficients, for example, in a unit according to three factors: (the number of "0s"), (the value of each non-zero DCT coefficient) , and (a flag indicating whether the current processing is on the final non-zero coefficient) , and performs inverse quantization on (the value of the non-zero DCT coefficient). The inter block processing section 21a skips reference positions in the rearrangement table 22 by the amount corresponding to (the number of "0s") included in the decoding result, and substitutes the results of inverse quantization of the non-zero DCT coefficient in the placement position indicated by the reference position after the skip.

Thus, inverse quantization can be performed without making a determination as to whether each DCT coefficient is "0", decoding, rearrangement and inverse quantization of one block can be completed by performing processing on non-zero DCT coefficients only, and the decoding processing speed can therefore be increased.

In the case where the DCT coefficients QF are quantized by the H.263 system, it is not necessary to consider the position of each DCT coefficient QF after rearrangement, as shown by the equation (3), when the DCT coefficient QF is dequantized. Therefore, when inverse quantization is performed, rearrangement and inverse quantization may be performed regardless of the order thereof.

On the other hand, in the case where the DCT coefficients QF are quantized by the MPEG system, the value QM of the quantization matrix corresponding to the position of each DCT coefficient QF after rearrangement is required, as shown by the equation (4) , when the DCT coefficient QF is dequantized. When inverse quantization is being performed, to perform the inverse quantization without combining the DCT coefficients QF into a block in the order of rearrangement, the rearrangement table 22 may be referred to and the value QM of the quantization matrix may be obtained on the basis of the result of this reference.

The intra block decoding section 21b decodes DCT coefficients of an intra block by referring to the code table 15 in Figure 13 (e) , and outputs the decoded DCT coefficients to the rearrangement section 2. The intra block decoding section 21b may also be arranged to perform rearrangement simultaneously with decoding by referring to the rearrangement table 22, thereby enabling a skip of processing in the rearrangement section 2.

In the rearrangement table 22, an order in which DCT coefficients are rearranged in a block is registered. For example, in a case where DCT coefficients to be decoded are zigzag-scanned, positions in a block for rearrangement of the DCT coefficients in raster scan order are registered.

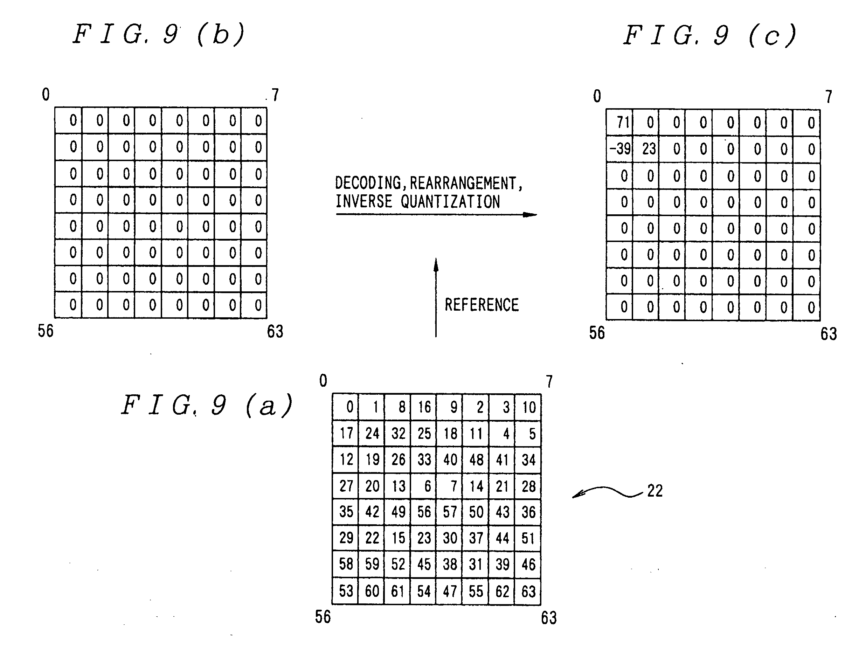

Figure 9(a) is a diagram showing the configuration of the rearrangement table 22 for rearranging in raster scan order DCT coefficients zigzag-scanned.

Referring to Figure 9(a), to rearrange in raster scan order DCT coefficients zigzag-scanned, it is necessary to change the placement of the DCT coefficients so that, for example, the DCT coefficient at the 0th position is placed at the 0th position, the DCT coefficient at the first position is placed at the first position, the DCT coefficient at the second position is placed at the eighth position, and the DCT coefficient at the third position is placed at the sixteenth position. For this rearrangement, the positions after rearrangement of the DCT coefficients are registered in raster scan order in the $8 \times 8$ block in the rearrangement table 22.

Figure 9 is a diagram showing a method of decoding DCT coefficients according to the fifth embodiment of the present inventionwith respect to an inter macroblock by way of example. In the description with reference to Figure 9, it is assumed that quantization is performed by the H.263 system, and that the quantization parameter QP is 8.

Referring to Figure 9(b), the inter block processing section 21a shown in Figure 8 initializes an $8 \times 8$ block to "0".

Subsequently, the inter block processing section 21a decodes the first DCT coefficient. If, for example, (the number of "0s" = 0), (the non-zero DCT coefficient value = "4") and (the flag indicating whether the current processing is on the final non-zero coefficient = "false") are obtained as a decoding result, the inter block processing section 21a refers to the rearrangement table 2 in Figure 9 (a) at the 0th position, and dequantizes (the non-zero DCT coefficient value = "4"). If the 0th position is thereby obtained as the position at which the decoding result of the 0th DCT coefficient is to be placed, and if "71" is obtained as a result of inverse quantization of (the non-zero DCT coefficient value = "4"), the inter block processing section 21a places the inverse quantization result = "71" at the 0th position in the block, as shown in Figure 9(c).

Subsequently, the inter block processing section 21a decodes the next DCT coefficient. If, for example, (thenumber of "0s" = 1), (the non-zero DCT coefficient value = "-2") and (the flag indicating whether the current processing is on the final non-zero coefficient = "false") are obtained as a decoding result, the inter block processing section 21a refers to the rearrangement table 22 in Figure 9(a) at the second position by skipping the reference position by the amount corresponding to the number of "0s" = 1, and dequantizes (the non-zero DCT coefficient value = "-2"). If the eighthposition is thereby obtained as the position at which the decoding result of the non-zero DCT coefficient is to be placed, and if "-39" is obtained as a result of inverse quantization of (the non-zero DCT coefficient value = "-2") at the present time, the inter block processing section 21a places the inverse quantization result = "-39" at the eighth position in the block, as shown in Figure 9(c).

Since "0" is previously substituted at the time of initialization of the block shown in Figure 9(b), none of the "0" placement positions becomes empty even though substitution of "0" in the block is performed with a skip by the amount corresponding to the number of "0s" = 1 when "-39" is placed at the eighth position in the block.

Subsequently, the inter block processing section 21a decodes the next DCT coefficient. If, for example, (the number of "0s" = 1), (the non-zero DCT coefficient value = "1") and (the flag indicating whether the current processing is on the final non-zero coefficient = "true") are obtained as a decoding result, the inter block processing section 21a refers to the rearrangement table 22 in Figure 9 (a) at the fourth position by skipping the reference positions by the amount corresponding to the number of "0s" = 1, and dequantizes (the non-zero DCT coefficient value = "1"). If the ninth position is thereby obtained as the position at which the decoding result of the non-zero DCT coefficient is to be placed, and if "23" is obtained as a result of inverse quantization of (the non-zero DCT coefficient value = "1") at the present time, the inter block processing section 21a places the inverse quantization result = "23" at the ninth position in the block, as shown in Figure 9(c). Since (the flag indicating whether the current processing is on the final non-zero coefficient = "true"), the inter block processing section 21a terminates decoding of the one block and outputs the inverse quantization result corresponding to the $8 \times 8$ block to the inverse DCT section 5.

As described above, inverse quantization is performed accompanying decoding to be completed simultaneously with the completion of decoding, and there is no need to make a determination as to "0"/ non-"0" when inverse quantization is performed, so that the decoding processing speed can be increased.

Also, since the dequantizedDCT coefficients can be placed in a block while being rearranged, the need for the storage area for holding the sixty-four DCT coefficients before rearrangement can be eliminated while only the storage area for holding the sixty-four DCT coefficients after rearrangement is prepared, thus making it possible to reduce the storage capacity.

Also, since inverse quantization is started by initializing the entire block to "0", there is no need for substitution of "0" in a block when the inverse quantization result is "0" and processing can be skipped by the amount corresponding to the number of "0s", thus making it possible to further increase the processing speed.

The fifth embodiment has been described with respect to the method in which the inter block processing section 21a decodes non-zero DCT coefficients in a unit according to three factors: (the number of "0s"), (the value of each non-zero DCT coefficient), and (a flag indicating whether the current processing is on the final non-zero coefficient). However, decoding may be performed by a method different from this.

For example, non-zero DCT coefficients may be decoded in a unit according to a set of (the number of "0s") and (the value of each non-zero DCT coefficient). In such a case, decoding of one block and inverse quantization may be terminated when an EOB (End of Block) code indicating that subsequent coefficients in the block are "0" is decoded.

Also, for example, in the case where quantization is performed by the H.263 system, the non-zero DCT coefficient QF may be decoded by referring to the code table 15 in Figure 13 (e) and may be dequantized by using the equation (3), and the non-zero DCT coefficient QF' may be decoded by referring to the computation table 14 in Figure 7 (e) andmaybe dequantized by using the equations (5) to (7).

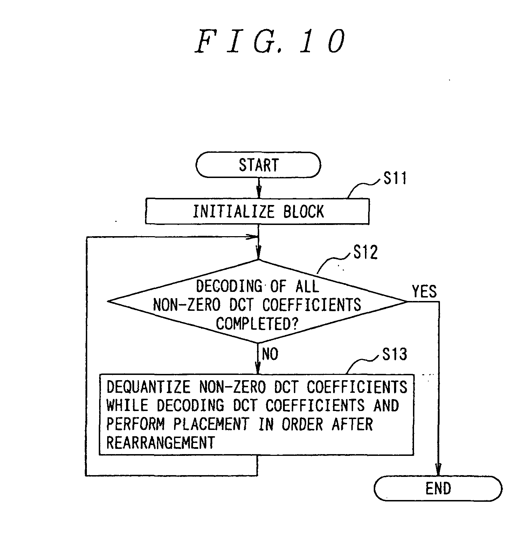

Figure 10 is a flowchart showing a method of decoding DCT coefficients according to the fifth embodiment of the present invention with respect to an inter macroblock by way of example.

Referring to Figure 10, the inter block processing section 21a initializes a block (step S11).

Next, if decoding of all non-zero DCT coefficients in the block is not completed (step S12), one of the variable-length coded DCT coefficients is decoded, the reference positions in the rearrangement table 22 are skipped by the amount corresponding to the number of "0s" included in the decoding result to obtain the placement position identified by the reference position after the skip, and the non-zero DCT coefficient is dequantized. The dequantized non-zero DCT coefficient is then substituted in the placement position obtained from the rearrangement table 22 (step S13).

The above-described processing is performed on all the non-zero DCT coefficients. After the completion of processing on all the non-zero DCT coefficients, the results of inverse quantization of the DCT coefficients combined into a block are output to the inverse DCT section 5.

As described above, decoding, rearrangement and inverse quantization of DCT coefficients are performed at a time with reference to the rearrangement table 22. In this manner, decoding, inverse quantization and rearrangement of all the DCT coefficients in one block can be completed simultaneously by scanning the non-zero DCT coefficients one time (step S12 in Figure 10), thus making it possible to reduce the load in decoding processing.

While the fifth embodiment has been described with respect to a case where the rearrangement table 22 is provided, decoding and inverse quantizationmaybe performed at a time with respect to a block without using the rearrangement table 22.

Also, in the case of processing on an intra block, both the computation table 14 in Figure 7(e) and the code table 15 in Figure 13(e) may be provided and selectively referred to in correspondence with the H.263 system or the MPEG system.

While the fifth embodiment has been describedwith respect to an application to the MPEG-4 system, applications to other systems are also possible. For example, an application to the MPEG-1 or MPEG-2 system or to the JPEG (Joint Photographic Experts Group) system is also possible.

While an example of the arrangement table in the case where DCT coefficients are zigzag-scanned has been described, an application to alternate scan is also possible. Also, the rearrangement table may be changed in correspondence with zigzag scan or alternate scan.

Industrial Applicability

According to the present invention, as described above, decoding results are rearranged while skipping 0s, thus making it possible to reduce the load at the time of rearrangement of decoding results and to increase the decoding speed.

**Claims**

1.  A decoder comprising:

    decoding means for decoding encoded data combined into a block; and
    placement means for placing a decoding result obtained by said decoding means at a position determined with a skip by the amount corresponding to the number of 0s if 0 is included in the decoding result.

2.  The decoder according to claim 1, wherein said placement means directlyplaces the decoding result at the position after rearrangement.

3.  A decoder comprising:

    decoding means for decoding encoded data combined into a block;
    inverse quantization means for dequantizing a decoding result obtained by said decoding means with a skip by the amount corresponding to the number of 0s if 0 is included in the decoding result; and
    placement means for directly placing a result of the inverse quantization at a position after rearrangement.

4.  A decoder comprising:

decoding means for decoding encoded data while performing part of computation processing for inverse quantization; and

inverse quantization means for dequantizing an output result from said decoding means by performing the rest of computation processing other than the part of computation processing performed by said decoding means.

5. A decoder comprising:

a rearrangement table in which a decoding result rearrangement order is registered; and decoding and rearrangement means for performing rearrangement of a decoding result with reference to said rearrangement table while performing decoding.

6. A decoder comprising:

a rearrangement table in which an order in which DCT coefficients are rearranged in a block is registered; and decoding and rearrangement means for placing a non-zero DCT coefficient in an initializedblock in the order designated by said rearrangement table each time it decodes a DCT coefficient.

7. The decoder according to claim 5, wherein said decoding and rearrangement means skips reference to said rearrangement table and substitution in the block by the amount corresponding to the number of 0s included in a decoding result if 0 is included in the decoding result.

8. A decoder comprising:

a lookup table in which a result of computation of an information source is registered in correspondence with a code assigned to the information source;
acquisitionmeans for obtaining the result of computation of the encoded information source by referring to said lookup table; and inverse quantization means for performing inverse quantization on the basis of the obtained computation result.

9. The decoder according to claim 8, wherein if the information source is X, the computation result is 2X + 1.

10. A decoder comprising:

decoding and inverse quantization means for performing inverse quantization while performing decoding; and

block-forming means for combining a result of inverse quantization performed by said decoding and inverse quantization means into a block.

11. The decoder according to claim 9, further comprising a lookup table in which a result of computation of an information source is registered in correspondence with a code assigned to the information source, said decoder being **characterized in that** said decoding and inverse quantization means obtains the result of computation of the encoded information source by referring to said lookup table and performs inverse quantization on the basis of the obtained computation result.

12. The decoder according to claim 10 or 11, further comprising a rearrangement table in which a decoding result rearrangement order is registered, said decoder being **characterized in that** said decoding and inverse quantization means performs inverse quantization of the decoding result on the basis of a result of reference to the decoding result rearrangement order.

13. The decoder according to anyone of claims 10 to 12, wherein said block-forming means combines into a block a result of the inverse quantization in the order after rearrangement by referring to said rearrangement table.

14. The decoder according to any one of claims 10 to 13, further comprising initialization means for initializing the block, said decoder being **characterized in that** said decoding and inverse quantization means skips inverse quantization by the amount corresponding to the number of 0s included in a decoding result if 0 is included in the decoding result.

15. The decoder according to claim 14, wherein said block-forming means skips reference to said rearrangement table and substitution in the block by the amount corresponding to the number of "0s".

16. Adecodingmethod for decoding codes while placing results of decoding in an order different from the order in which the codes are decoded.

17. A decoding method comprising the steps of:

initial i zing a block in which DCT coefficients are placed; and
placing a non-zero DCT coefficient in the block, skipping processing after the initializing step regarding "0", if information indicating "0" is included in a decoding result.

18. A decoding method comprising the steps of:

initializing a block in which DCT coefficients are placed;

decoding an encoded DCT coefficient;

obtaining a rearrangement order in which a non-zero DCT coefficient is placed each time decoding of a DCT coefficient is performed, and placing the non-zero DCT coefficient in the initialized block in the obtained rearrangement order.

**19.** A decoding method for performing decoding and inverse quantization at a time with respect to each of blocks.

**20.** A decoding method for performing decoding, rearrangement and inverse quantization at a time with respect to each of blocks.

**21.** A decoding method comprising the steps of:

performing inverse quantization each time a code is decoded; and

combining results of the inverse quantization into a block in an order different from the decoding order.

**22.** A decoding method comprising the steps of:

initializing a block in which DCT coefficients are placed;

skipping inverse quantization processing with respect to "0" if information indicating "0" is included in a decoding result; and

dequantizing a decoded non-zero DCT coefficient and placing the result of the inverse quantization in the block.

**23.** A decoding method comprising the steps of:

initializing a block in which DCT coefficients are placed;

skipping inverse quantization processing with respect to "0" if information indicating "0" is included in a decoding result;

obtaining a rearrangement order in which a decoded non-zero DCT coefficient is placed, and dequantizing the non-zero DCT coefficient and placing the result of the inverse quantization in the block in the rearrangement order.

**24.** A lookup table wherein placement positions for rearranging zigzag-scanned or alternate-scanned DCT coefficients in raster scan order are registered.

**25.** A lookup table wherein a result of computation of an information source is registered in correspondence with a code assigned to the information source.

**26.** A decoding program for making a computer execute:

a step of inputting codes combined into a block; and

a step of placing in a block a result of decoding of the codes so that the state in which the result of decoding is newlyplaced is different from the preceding state of placement of the codes each time decoding is performed on the codes.

**27.** A decoding program for making a computer execute:

a step of decoding encoded data; and

a step of placing a decoding result in a block with a skip by the amount corresponding to the number of 0s if 0 is included in the decoding result.

**28.** A decoding program for making a computer execute:

a step of inputting codes combined into a block; a step of performing inverse quantization while decoding the codes; and

a step of combining results of the inverse quantization into a block while changing the placement order.

**Amended claims under Art. 19.1 PCT**

(Received on October 25, 2002 by the International Bureau. Claims 1, 2, 5 to 7 and 16 to 18 are cancelled, and the remaining claims are unchanged.)

**1.** Cancelled)

**2.** Cancelled)

**3.** A decoder comprising:

decoding means for decoding encoded data combined into a block;

inverse quantization means for dequantizing a decoding result obtained by said decoding means with a skip by the amount corresponding to the number of 0s if 0 is included in the decoding result; and

placement means for directly placing a result of the inverse quantization at a position after rearrangement.

**4.** A decoder comprising:

decoding means for decoding encoded data while performing part of computation processing for inverse quantization; and
inverse quantization means for dequantizing an output result from said decoding means by performing the rest of computation processing other than the part of computation processing performed by said decoding means.

**5.** Cancelled)

**6.** Cancelled)

**7.** Cancelled)

**8.** A decoder comprising:

a lookup table in which a result of computation of an information source is registered in correspondence with a code assigned to the information source;
acquisitionmeans for obtaining the result of computation of the encoded information source by referring to said lookup table; and
inverse quantization means for performing inverse quantization on the basis of the obtained computation result.

**9.** The decoder according to claim 8, wherein if the information source is X, the computation result is 2X + 1.

**10.** A decoder comprising:

decoding and inverse quantization means for performing inverse quantization while performing decoding; and
block-forming means for combining a result of inverse quantization performed by said decoding and inverse quantization means into a block.

**11.** The decoder according to claim 9, further comprising a lookup table in which a result of computation of an information source is registered in correspondence with a code assigned to the information source, said decoder being **characterized in that** said decoding and inverse quantization means obtains the result of computation of the encoded information source by referring to said lookup table and performs inverse quantization on the basis of the obtained computation result.

**12.** The decoder according to claim 10 or 11, further comprising a rearrangement table in which a decoding result rearrangement order is registered, said decoder being **characterized in that** said decoding and inverse quantization means performs inverse quantization of the decoding result on the basis of a result of reference to the decoding result rearrangement order.

**13.** The decoder according to anyone of claims 10 to 12, wherein said block-forming means combines into a block a result of the inverse quantization in the order after rearrangement by referring to said rearrangement table.

**14.** The decoder according to any one of claims 10 to 13, further comprising initialization means for initializing the block, said decoder being **characterized in that** said decoding and inverse quantization means skips inverse quantization by the amount corresponding to the number of 0s included in a decoding result if 0 is included in the decoding result.

**15.** The decoder according to claim 14, wherein said block-forming means skips reference to said rearrangement table and substitution in the block by the amount corresponding to the number of "0s".

**16.** Cancelled)

**17.** Cancelled)

**18.** Cancelled)

**19.** A decoding method for performing decoding and inverse quantization at a time with respect to each of blocks.

**20.** A decoding method for performing decoding, rearrangement and inverse quantization at a time with respect to each of blocks.

**21.** A decoding method comprising the steps of:

performing inverse quantization each time a code is decoded; and
combining results of the inverse quantization into ablock in an order different from the decoding order.

**22.** A decoding method comprising the steps of:

initializing a block in which DCT coefficients are placed;
skipping inverse quantization processing with respect to "0" if information indicating "0" is included in a decoding result; and
dequantizing a decoded non-zero DCT coefficient and placing the result of the inverse quantization in the block.

**23.** A decoding method comprising the steps of:

initializing a block in which DCT coefficients are placed;

skipping inverse quantization processing with respect to "0" if information indicating "0" is included in a decoding result;

obtaining a rearrangement order in which a decoded non-zero DCT coefficient is placed, and dequantizing the non-zero DCT coefficient and placing the result of the inverse quantization in the block in the rearrangement order.

**24.** A lookup table wherein placement positions for rearranging zigzag-scanned or alternate-scanned DCT coefficients in raster scan order are registered.

**25.** A lookup table wherein a result of computation of an information source is registered in correspondence with a code assigned to the information source.

**26.** A decoding program for making a computer execute:

a step of inputting codes combined into a block; and

a step of placing in a block a result of decoding of the codes so that the state in which the result of decoding is newly placed is different from the preceding state of placement of the codes each time decoding is performed on the codes.

**27.** A decoding program for making a computer execute:

a step of decoding encoded data; and

a step of placing a decoding result in a block with a skip by the amount corresponding to the number of 0s if 0 is included in the decoding result.

**28.** A decoding program for making a computer execute:

a step of inputting codes combined into a block;

a step of performing inverse quantization while decoding the codes; and

a step of combining results of the inverse quantization into a block while changing the placement order.

# F I G. 1

ENCODED DATA

↓

┌─────────────────┐ 101
│   DECODING      │
│    MEANS        │
└─────────────────┘

↓

┌─────────────────┐ 102      ┌─────────────────┐ 103
│   PLACEMENT     │──────────│  REARRANGEMENT  │
│     MEANS       │          │     TABLE       │
└─────────────────┘          └─────────────────┘

↓

DECODING RESULT

EP 1 401 106 A1

# FIG. 2

EP 1 401 106 A1

## FIG. 3 (b)

| 0 | | | | | | | 7 |
|---|---|---|---|---|---|---|---|
| 0 | 0 | 0 | 0 | 0 | 0 | 0 | 0 |
| 0 | 0 | 0 | 0 | 0 | 0 | 0 | 0 |
| 0 | 0 | 0 | 0 | 0 | 0 | 0 | 0 |
| 0 | 0 | 0 | 0 | 0 | 0 | 0 | 0 |
| 0 | 0 | 0 | 0 | 0 | 0 | 0 | 0 |
| 0 | 0 | 0 | 0 | 0 | 0 | 0 | 0 |
| 0 | 0 | 0 | 0 | 0 | 0 | 0 | 0 |
| 0 | 0 | 0 | 0 | 0 | 0 | 0 | 0 |

56     63

## FIG. 3 (c)

| 0 | | | | | | | 7 |
|---|---|---|---|---|---|---|---|
| 4 | 0 | 0 | 0 | 0 | 0 | 0 | 0 |
| -2 | 1 | 0 | 0 | 0 | 0 | 0 | 0 |
| 0 | 0 | 0 | 0 | 0 | 0 | 0 | 0 |
| 0 | 0 | 0 | 0 | 0 | 0 | 0 | 0 |
| 0 | 0 | 0 | 0 | 0 | 0 | 0 | 0 |
| 0 | 0 | 0 | 0 | 0 | 0 | 0 | 0 |
| 0 | 0 | 0 | 0 | 0 | 0 | 0 | 0 |
| 0 | 0 | 0 | 0 | 0 | 0 | 0 | 0 |

56     63

DECODING AND
REARRANGEMENT
→

REFERENCE

## FIG. 3 (a)

| 0 | | | | | | | 7 |
|---|---|---|---|---|---|---|---|
| 0 | 1 | 8 | 16 | 9 | 2 | 3 | 10 |
| 17 | 24 | 32 | 25 | 18 | 11 | 4 | 5 |
| 12 | 19 | 26 | 33 | 40 | 48 | 41 | 34 |
| 27 | 20 | 13 | 6 | 7 | 14 | 21 | 28 |
| 35 | 42 | 49 | 56 | 57 | 50 | 43 | 36 |
| 29 | 22 | 15 | 23 | 30 | 37 | 44 | 51 |
| 58 | 59 | 52 | 45 | 38 | 31 | 39 | 46 |
| 53 | 60 | 61 | 54 | 47 | 55 | 62 | 63 |

56     63

―12

## F I G. 4

```
           START
             │
             ▼              ╭─ S1
    ┌─────────────────┐
    │ INITIALIZE BLOCK │
    └─────────────────┘
             │
    ┌────────┤
    │        ▼              ╭─ S2
    │      ╱DECODING OF ALL╲         YES
    │    ╱  NON-ZERO DCT     ╲──────────┐
    │    ╲  COEFFICIENTS    ╱           │
    │      ╲ COMPLETED?   ╱             │
    │         NO                        │
    │        ▼              ╭─ S3       │
    │  ┌──────────────────────────┐     │
    │  │ DECODE DCT COEFFICIENTS AND│    │
    │  │ PLACE NON-ZERO DCT COEFFICIENTS│ │
    │  │ IN ORDER AFTER REARRANGEMENT│   │
    │  └──────────────────────────┘     │
    └────────┘                          ▼
                                      END
```

## F I G. 5

```
        ENCODED DATA
             │
             ▼              ╭─ 201              ╭─ 203
    ┌─────────────────┐          ┌────────────┐
    │ DECODING MEANS  │──────────│ COMPUTATION │
    └─────────────────┘          │   TABLE     │
             │                    └────────────┘
             ▼              ╭─ 202
    ┌─────────────────┐
    │     INVERSE     │
    │  QUANTIZATION   │
    │     MEANS       │
    └─────────────────┘
             │
             ▼
    INVERSE QUANTIZATION RESULT
```

## *FIG. 6*

INPUT BIT SEQUENCE → **VARIABLE-LENGTH DECODER** (13) → DCT COEFFICIENT → **REARRANGEMENT** (2) → **DC/AC PREDICTION** (3) → **INVERSE QUANTIZATION** (4) → **INVERSE DCT** (5) → (+) (9) → OUTPUT DATA

**COMPUTATION TABLE** (14)

MOTION VECTOR → **MOTION COMPENSATION** (8)

**PAST REFERENCE FRAME** (7) ← **PRESENT FRAME** (6)

EP 1 401 106 A1

FIG. 7 (a)    FIG. 7 (b)    FIG. 7 (c)    FIG. 7 (d)

DECODING    REARRANGEMENT    INVERSE QUANTIZATION

REFERENCE

FIG. 7 (e)

| CODE | QF′ |
|------|-----|
| 0s | 1*2+1 |
| 10s | 2*2+1 |
| 110s | 3*2+1 |
| 1110s | 4*2+1 |
| ⋮ | ⋮ |

14

FIG. 8

EP 1 401 106 A1

FIG. 9 (b)

FIG. 9 (c)

FIG. 9 (b)

| 0 | | | | | | | 7 |
|---|---|---|---|---|---|---|---|
| 0 | 0 | 0 | 0 | 0 | 0 | 0 | 0 |
| 0 | 0 | 0 | 0 | 0 | 0 | 0 | 0 |
| 0 | 0 | 0 | 0 | 0 | 0 | 0 | 0 |
| 0 | 0 | 0 | 0 | 0 | 0 | 0 | 0 |
| 0 | 0 | 0 | 0 | 0 | 0 | 0 | 0 |
| 0 | 0 | 0 | 0 | 0 | 0 | 0 | 0 |
| 0 | 0 | 0 | 0 | 0 | 0 | 0 | 0 |
| 0 | 0 | 0 | 0 | 0 | 0 | 0 | 0 |

56    63

DECODING, REARRANGEMENT,
INVERSE QUANTIZATION
→

↑ REFERENCE

FIG. 9 (c)

| 0 | | | | | | | 7 |
|---|---|---|---|---|---|---|---|
| 71 | 0 | 0 | 0 | 0 | 0 | 0 | 0 |
| -39 | 23 | 0 | 0 | 0 | 0 | 0 | 0 |
| 0 | 0 | 0 | 0 | 0 | 0 | 0 | 0 |
| 0 | 0 | 0 | 0 | 0 | 0 | 0 | 0 |
| 0 | 0 | 0 | 0 | 0 | 0 | 0 | 0 |
| 0 | 0 | 0 | 0 | 0 | 0 | 0 | 0 |
| 0 | 0 | 0 | 0 | 0 | 0 | 0 | 0 |
| 0 | 0 | 0 | 0 | 0 | 0 | 0 | 0 |

56    63

FIG. 9 (a)

| 0 | | | | | | | 7 |
|---|---|---|---|---|---|---|---|
| 0 | 1 | 8 | 16 | 9 | 2 | 3 | 10 |
| 17 | 24 | 32 | 25 | 18 | 11 | 4 | 5 |
| 12 | 19 | 26 | 33 | 40 | 48 | 41 | 34 |
| 27 | 20 | 13 | 6 | 7 | 14 | 21 | 28 |
| 35 | 42 | 49 | 56 | 57 | 50 | 43 | 36 |
| 29 | 22 | 15 | 23 | 30 | 37 | 44 | 51 |
| 58 | 59 | 52 | 45 | 38 | 31 | 39 | 46 |
| 53 | 60 | 61 | 54 | 47 | 55 | 62 | 63 |

⟋ 22

56    63

# *F I G. 1 0*

```
                    ┌─────────────┐
                    │    START    │
                    └─────────────┘
                           │
                           ▼                        S11
              ┌─────────────────────────┐
              │    INITIALIZE BLOCK     │
              └─────────────────────────┘
                           │
        ┌──────────────────┤
        │                  ▼                        S12
        │            ╱───────────────╲
        │          ╱   DECODING OF ALL  ╲        YES
        │         ⟨  NON-ZERO DCT COEFFICIENTS ⟩──────┐
        │          ╲    COMPLETED?    ╱              │
        │            ╲───────────────╱               │
        │                  │ NO                      │
        │                  ▼            S13          │
        │  ┌───────────────────────────────────┐    │
        │  │ DEQUANTIZE NON-ZERO DCT COEFFICIENTS│   │
        │  │ WHILE DECODING DCT COEFFICIENTS AND │   │
        │  │ PERFORM PLACEMENT IN ORDER AFTER    │   │
        │  │ REARRANGEMENT                       │   │
        │  └───────────────────────────────────┘    │
        │                  │                         ▼
        └──────────────────┘              ┌─────────────┐
                                          │     END     │
                                          └─────────────┘
```

FIG. 11

EP 1 401 106 A1

## F I G. 1 2 (a)

## F I G. 1 2 (b)

## F I G. 1 2 (c)

## F I G. 1 2 (d)

EP 1 401 106 A1

# FIG. 13 (a)   FIG. 13 (b)   FIG. 13 (c)   FIG. 13 (d)

DECODING

REARRANGE-MENT

INVERSE QUANTIZATION

(a)   (b)   (c)   (d)

REFERENCE

## FIG. 13 (e)

| CODE | QF |
|------|----|
| 0s | 1 |
| 10s | 2 |
| 110s | 3 |
| 1110s | 4 |
| ⋮ | ⋮ |

~15

EP 1 401 106 A1

# FIG. 14

```
                    ┌─────────────┐
                    │    START    │
                    └──────┬──────┘
                           │              ╭─ S21
                    ┌──────▼──────────┐
           ┌───────►│ INITIALIZE BLOCK│
           │        └──────┬──────────┘
           │               │              ╭─ S22
           │          ╱────▼─────╲
           │         ╱  DECODING OF╲      YES
           │        ╱ ALL DCT COEFF.╲────────────┐
           │        ╲  COMPLETED?   ╱            │
           │         ╲──────┬──────╱             │
           │          │ NO                       │
           │          │              ╭─ S23      │
           │   ┌──────▼──────────────┐           │
           │   │ DECODE DCT COEFF.   │           │
           │   │ AND PLACE THEM IN   │           │
           │   │ BLOCK IN DECODING   │           │
           │   │ ORDER               │           │
           │   └──────┬──────────────┘           │
           └──────────┘                          │
                        ┌──────────────◄─────────┘
                        │              ╭─ S24
           ┌───────────►▼
           │       ╱──────────╲
           │      ╱ REARRANGEMENT╲     YES
           │     ╱  OF ALL DCT    ╲──────────────┐
           │     ╲  COEFFICIENTS  ╱              │
           │      ╲  COMPLETED?  ╱               │
           │       ╲─────┬──────╱                │
           │         │ NO          ╭─ S25        │
           │  ┌──────▼────────────┐              │
           │  │ REARRANGE DCT     │              │
           │  │ COEFFICIENTS IN   │              │
           │  │ RASTER SCAN ORDER │              │
           │  └──────┬────────────┘              │
           └─────────┘                           │
                       ┌──────────────◄──────────┘
                       │             ╭─ S26
           ┌──────────►▼
           │      ╱──────────╲
           │     ╱  INVERSE   ╲        YES
           │    ╱ QUANTIZATION ╲──────────────┐
           │    ╲ OF ALL DCT   ╱              │
           │    ╲ COMPLETED?  ╱               │
           │     ╲────┬──────╱                │
           │      │ NO         ╭─ S27         │
           │   ╱───▼────╲                     │
      YES  │  ╱   DCT     ╲                   │
      ◄────┼─╱ COEFFICIENT ╲                  │
           │  ╲   = 0?    ╱                   │
           │   ╲───┬─────╱                    │
           │     │ NO        ╭─ S28           │
           │ ┌───▼────────────────┐           │
           │ │ DEQUANTIZE DCT     │           │
           │ │ COEFFICIENT        │           │
           │ └───┬────────────────┘           │
           └─────┘                            │
                                       ┌──────▼──────┐
                                       │     END     │
                                       └─────────────┘
```

## INTERNATIONAL SEARCH REPORT

| | International application No. |
| --- | --- |
| | PCT/JP02/05287 |

**A. CLASSIFICATION OF SUBJECT MATTER**
Int.Cl⁷ H03M7/30

According to International Patent Classification (IPC) or to both national classification and IPC

**B. FIELDS SEARCHED**

Minimum documentation searched (classification system followed by classification symbols)
Int.Cl⁷ H03M7/30

Documentation searched other than minimum documentation to the extent that such documents are included in the fields searched
Jitsuyo Shinan Koho(Y1,Y2)   1926-1996   Toroku Jitsuyo Shinan Koho(U)   1994-2002
Kokai Jitsuyo Shinan Koho(U)   1971-2002   Jitsuyo Shinan Toroku Koho(Y2)   1996-2002

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 07-273663 A   (Mitsubishi Electric Corp.), 20 October, 1995 (20.10.95), Par. No. [0060] & US 6134349 A | 1-28 |
| X | JP 08-116268 A   (Toshiba Corp.), 07 May, 1996 (07.05.96), Par. No. [0021] (Family: none) | 1-28 |
| A | JP 03-266564 A   (Canon Inc.), 27 November, 1991 (27.11.91), Fig. 5 (Family: none) | 1-28 |

☐ Further documents are listed in the continuation of Box C.      ☐ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 03 September, 2002 (03.09.02) | 17 September, 2002 (17.09.02) |

| Name and mailing address of the ISA/ | Authorized officer |
| --- | --- |
| Japanese Patent Office | |
| Facsimile No. | Telephone No. |

Form PCT/ISA/210 (second sheet) (July 1998)